# EUROPÄISCHE PATENTSCHRIFT

(11) **EP 3 087 214 B1**
(45) Veröffentlichungstag und Bekanntmachung des Hinweises auf die Patenterteilung: **07.10.2020**
(21) Anmeldenummer: 14838773.1
(22) Anmeldetag: 18.12.2014
(51) Int. Cl.: C23C 8/06, C23C 8/18, C23C 8/80, C25D 7/10, C25D 11/34, C22C 13/00, C23C 8/14, F16C 33/12, C23C 28/00, F16C 17/02

(54) **MEHRSCHICHTGLEITLAGER**
MULTI-LAYER SLIDING BEARING
PALIER LISSE MULTICOUCHE

(30) Priorität: 23.12.2013 AT 508512013
(43) Veröffentlichungstag der Anmeldung: 02.11.2016
(73) Patentinhaber: Miba Gleitlager Austria GmbH, 4663 Laakirchen (AT)
(72) Erfinder: ZIDAR, Jakob, A-4813 Altmünster (AT)
(74) Vertreter: Burger, Hannes
(86) Internationale Anmeldenummer: PCT/AT2014/050304
(87) Internationale Veröffentlichungsnummer: WO 2015/095906

(56) Entgegenhaltungen:
- EP-A1- 2 135 969
- DE-A1- 10 054 461
- DE-B3-102010 040 469
- GB-A- 2 310 691
- JP-A- 2005 054 237
- JP-A- 2009 270 176

## Beschreibung

Die Erfindung betrifft ein Mehrschichtgleitlager umfassend eine Gleitschicht mit einer Oberfläche zur Anlage an ein zu lagerndes Bauteil, wobei die Gleitschicht aus einer Zinnbasislegierung mit Zinn als Hauptlegierungselement gebildet ist.

Zinnbasislegierungen werden bereits seit langer Zeit für Gleitlager für die Motorenindustrie als Werkstoff verwendet. Es sei in diesem Zusammenhang nur das Stichwort Weißmetall erwähnt.

In der einschlägigen Literatur werden unterschiedlichste Zusammensetzungen und Ausprägungen von Zinnbasislegierungen beschrieben, da sich die Anforderungen an die Gleitlager durch verbesserte Motoren und Betriebsmittel für Motoren im Laufe der Zeit verändert haben. Es sei beispielhaft die AT 509 112 A1 erwähnt aus der eine Gleitschicht für ein Mehrschichtgleitlager aus einer Zinnbasislegierung bekannt ist, die neben Zinn als Hauptlegierungselement zumindest ein Element aus der Gruppe Antimon und Kupfer, gegebenenfalls Blei und/oder Bismut, sowie aus der Herstellung der Elemente stammende unvermeidbare Verunreinigungen enthält, wobei der Antimonanteil maximal 20 Gew.-%, der Kupferanteil maximal 10 Gew.-%, der Summenanteil an Blei und Bismut maximal 1,5 Gew.-% und der Summenanteil an Kupfer und Antimon zwischen 2 Gew.-% und 22 Gew.-% betragen, und wobei Zinn in Form intermetallischer Phasen und als Zinnphase mit Beta-Zinnkörnern in einer bestimmten Orientierung vorliegt.

Aus dem durch die US 5,387,461 A bekannten Stand der Technik ist weiter bekannt, bei aluminiumbasierten Gleitlagerlegierungen eine Schicht aus einer Mischung aus Aluminiumoxid und Zinnoxid durch anodische Oxidation zu erzeugen, um damit den Fresswiderstand zu verbessern. Das Zinnoxid dient dabei als Festschmierstoff.

Die DE 10 2010 040469 B3 beschreibt einen Schichtverbundwerkstoff für Gleitelemente, umfassend eine auf die Oberfläche eines Gleitelements aufgebrachte Grundschicht aus einer Kupfer oder Aluminium enthaltenden Legierung und eine darüber befindliche Gleitschicht, die 90-99,6 Gew.-% Zinn oder Zinnlegierung mit einem Zinnanteil von mehr als 60 Gew.-%, 0,2-6 Gew.-% Feststoffschmierpartikel mit einer Mohs-Härte ≤ 3 und einer Korngröße ≤ 10 µm und 0,2-4 Gew.-% Hartstoffpartikel mit einer Mohs-Härte ≥ 8 und einer Korngröße ≤ 5 µm umfasst.

Aus der GB 2 310 691 A ist ein Gleitlager bekannt, das zur Reduktion von Reibverschleiß an mindestens einer der Außenflächen des Lagers mit einer Überzugsschicht bedeckt ist, die aus 3 bis 50 Gew.-% Festschmiermittel, 1 bis 50 Gew.-% harten Partikeln besteht, wobei der Rest aus Polyamidimidharz gebildet ist. Die harten Teilchen können ein Oxid. Die Schicht kann 2-30 µm dick sein.

Der vorliegenden Erfindung liegt die Aufgabe zu Grunde, ein Mehrschichtgleitlager mit einer zinnbasierten Gleitschicht anzugeben, das eine verbesserte Tragfähigkeit aufweist.

Die Aufgabe wird bei dem eingangs genannten Mehrschichtgleitlager dadurch gelöst, dass die Gleitschicht an der Oberfläche zumindest bereichsweise eine oxidische Subschicht aufweist, in der der Anteil an Zinnoxid zumindest 70 Gew.-% beträgt.

Von Vorteil ist dabei, dass damit der Einfluss von kurzfristigen Temperaturspitzen auf das relativ niedrig schmelzende Basismaterial der Gleitschicht reduziert werden kann. Ohne an die Erklärung des Effektes gebunden zu sein, wird vermutet, dass dies einerseits daran liegt, dass Zinnoxid eine deutlich schlechtere Wärmeleitfähigkeit aufweist als das Zinn der Zinnbasislegierung. Andererseits könnten auch Phasenumwandlungen eine Rolle spielen, indem nämlich das Zinnoxid zu elementaren Zinn und vierwertigem Zinnoxid reagiert. Diese Phasenumwandlung ist dabei mit einem Energieverbrauch verbunden, der eine Reduzierung der Temperaturbelastung bewirkt. Bei einem Anteil an Zinnoxid in der oxidischen Subschicht der geringer als 70 Gew.-% ist, wurde zwar der genannte Effekt der Reduzierung des Einflusses von Temperaturspitzen auf die Tragfähigkeit der Gleitschicht beobachtet, allerdings war dieser zu gering, um eine nennenswerte Verbesserung der Tragfähigkeit zu erreichen. Ein weiterer Vorteil des Mehrschichtgleitlagers nach der Erfindung ist, dass die oxidische Subschicht aus der Gleitschicht selbst erzeugt werden kann, sodass also kein zusätzlicher Abscheideprozess für eine Oxidschicht an der später mit dem Schmiermittel in Kontakt stehenden Gleitschicht erforderlich ist, wenngleich die gesonderte Abscheidung natürlich möglich ist. Durch die Erzeugung der oxidischen Subschicht aus dem Werkstoff der Gleitschicht selbst wird zudem eine bessere Haftung der Subschicht erreicht.

Gemäß einer bevorzugten Ausführungsvariante des Mehrschichtgleitlagers kann vorgesehen sein, dass sich die oxidische Subschicht über zumindest 80 % der Oberfläche erstreckt. Es wird damit eine Verbesserung der voranstehend genannten Effekte erreicht, insbesondere in Hinblick auf die verringerte thermische Leitfähigkeit der Gleitschicht an der Oberfläche.

Bevorzugt weisen zumindest 50 % der Fläche der oxidischen Subschicht eine Schichtdicke auf, die mindestens 0,1 µm beträgt. Es wurde damit eine deutliche Verbesserung der thermischen Barrierewirkung der oxidischen Subschicht erreicht. Darüber hinaus ist mit einer Schichtdicke von mindestens 0,1 µm das darunter liegende Zinnbasismaterial besser vor Korrosion geschützt.

Weiter ist bevorzugt, wenn zumindest 50 % der Fläche der oxidischen Subschicht eine Schichtdicke aufweisen, die maximal 2 µm beträgt. Es wird damit erreicht, dass die oxidische Subschicht noch so "flexibel" ist, dass sie die Anpassung der darunter liegenden Teile der Gleitschicht aus der Zinnbasislegierung an das zu lagernde Bauteil, beispielsweise eine Welle, zumindest weitgehend ohne Beschädigung mitvollzieht.

Nach einer anderen Ausführungsvariante des Mehrschichtgleitlagers kann vorgesehen sein, dass die Gleitschicht unterhalb der oxidischen Subschicht oxidische Bereiche aufweist. Es können damit die voranstehenden Effekte weiter verbessert werden, ohne dass auf der Oberfläche der Gleitschicht eine oxidische Subschicht aufgebracht werden muss, die eine höhere Schichtdicke aufweist.

Das Zinnoxid kann insbesondere zu mehr als 40 Gew.-% in der Modifikation Romarchit vorliegen. Es konnte beobachtet werden, dass damit die voranstehenden Effekte verbessert werden. Wie bereits voranstehend ausgeführt, wird vermutet, dass die Verbesserung der Temperaturstabilität auch über den Energieverbrauch von Phasenumwandlungen erfolgt. Romarchit kann durch mechanischen Belastung in die rote SnO-Modifikation mit orthorhombischer Struktur umgewandelt werden, bevor sich das SnO in Sn und SnO₂ umwandelt. Da die mechanische Belastung des Gleitlagers infolge der Verringerung der Viskosität des Schmieröls mit der Temperatur zunehmen kann, ist es möglich auch über diesen Weg den Temperaturanstieg zu verringern.

Gemäß einer Ausführungsvariante dazu kann vorgesehen sein, dass neben Romarchit auch vierwertiges Zinnoxid in der oxidischen Subschicht enthalten ist. Es wird damit zusätzlich zur Verbesserung der Temperaturstabilität des Gleitlagers in Grenzen eine Polierwirkung auf die Oberfläche des gelagerten Bauteils erreicht werden, wodurch das Einlaufverhalten der Zinnoxidschicht verbessert werden kann.

In der oxidischen Subschicht kann aus den nachfolgend noch näher erläuterten Gründen zumindest ein nichtmetallisches Element enthalten sein, das ausgewählt ist aus einer Gruppe umfassend Kohlenstoff, Wasserstoff und Schwefel, bzw. kann nach einer weiteren Ausführungsvariante vorgesehen sein, dass in der oxidischen Subschicht zumindest ein Element enthalten ist, das ausgewählt ist aus einer Gruppe umfassend Antimon, Kupfer, Indium, Bismut, Blei sowie die Oxide dieser Elemente und die Sulfide dieser Elemente.

Es kann weiter vorgesehen sein, dass die oxidische Subschicht Poren und/oder Risse aufweist. Damit wird erreicht, dass das Schmiermittel in diese Poren und/oder Risse der oxidischen Subschicht eindringen kann, wodurch die thermische Barrierewirkung der oxidischen Subschicht weiter verbessert werden kann.

Zum besseren Verständnis der Erfindung wird diese anhand der nachfolgenden Figuren näher erläutert.

Es zeigen jeweils in vereinfachter, schematischer Darstellung:
- Fig. 1: ein Mehrschichtgleitlager in Form einer Gleitlagerhalbschale in Seitenansicht;
- Fig. 2: Einen Schnitt durch einen Ausschnitt aus einer Gleitschicht in Schrägansicht.

Einführend sei festgehalten, dass die in der Beschreibung gewählten Lageangaben, wie z.B. oben, unten, seitlich usw. auf die unmittelbar beschriebene sowie dargestellte Figur bezogen sind und sind diese Lageangaben bei einer Lageänderung sinngemäß auf die neue Lage zu übertragen.

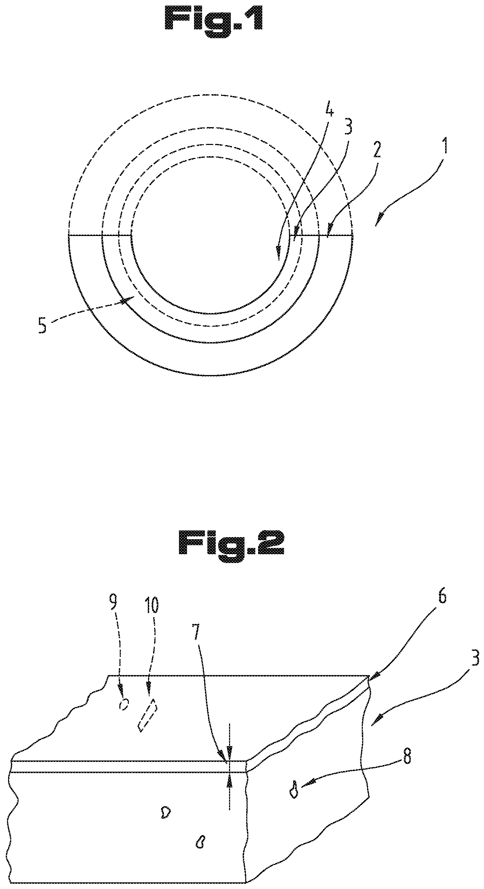

Fig. 1 zeigt ein Mehrschichtgleitlager 1 in Form einer Gleitlagerhalbschale. Dargestellt ist eine zweischichtige Variante des Mehrschichtgleitlagers 1, bestehend aus einer Stützschicht 2 und einer Gleitschicht 3, die auf einer Vorderseite 4 (radial innere Seite) des Mehrschichtgleitlagers 1, die einem zu lagernden Bauteil zuwendbar ist, angeordnet ist.

Gegebenenfalls kann eine Lagermetallschicht 5 zwischen der Gleitschicht 3 und der Stützschicht 2 angeordnet sein, wie dies in Fig. 1 strichliert angedeutet ist.

Der prinzipielle Aufbau derartiger Mehrschichtgleitlager 1, wie sie z.B. in Verbrennungskraftmaschinen Verwendung finden, ist aus dem Stand der Technik bekannt, sodass sich weitere Ausführungen hierzu erübrigen. Es sei jedoch erwähnt, dass weitere Schichten angeordnet werden können, also beispielsweise zwischen der Gleitschicht 4 und der Lagermetallschicht 5 eine Haftvermittlerschicht und/oder eine Diffusionssperrschicht, ebenso kann zwischen der Lagermetallschicht 3 und der Stützschicht 2 eine Haftmittelschicht angeordnet werden.

Im Rahmen der Erfindung kann das Mehrschichtgleitlager 1 auch anders ausgeführt sein, beispielsweise als Lagerbuchse, wie dies in Fig. 1 strichliert angedeutet ist. Ebenso sind Ausführungen wie Anlaufringe, axial laufende Gleitschuhe, oder dergleichen möglich.

Die Stützmetallschicht 2 besteht bevorzugt aus Stahl, kann aber auch aus einem Werkstoff, der dem Mehrschichtgleitlager 1 die erforderliche Strukturfestigkeit verleiht, bestehen. Derartige Werkstoffe sind aus dem Stand der Technik bekannt.

Für die Lagermetallschicht 5 sowie die Zwischenschichten können die aus dem einschlägigen Stand der Technik bekannten Legierungen bzw. Werkstoffe verwendet werden, und sei diesbezüglich darauf verwiesen.

Die Gleitschicht 3 besteht aus einer Zinnbasislegierung mit Zinn als Hauptlegierungselement, d.h. dass der Mengenanteil von Zinn in Bezug auf die einzelnen Mengenanteile der weiteren Legierungselemente und Legierungskomponenten am größten ist.

Vorzugsweise beträgt der Summengehalte der weiteren Legierungselemente und Legierungskomponenten zwischen 15 Gew.-% und 34 Gew.-%, insbesondere zwischen 20 Gew.-% und 30 Gew.-%. Den Rest auf 100 Gew.-% bildet Zinn.

Als weitere Legierungselemente und Legierungskomponenten neben Zinn enthält die Zinnbasislegierung bevorzugt zumindest eines der in Tabelle 1 aufgelisteten Legierungselemente und Legierungskomponenten. In der zweiten Spalte ist dabei der jeweilige Mengenanteil in Gew.-%, in der dritten Spalte der jeweilige bevorzugte Mengenanteil in Gew.-% und in der dritten Spalte sind die Effekte angeführt, die mit der Zugabe des jeweiligen Elementes erreicht werden.

**Tabelle 1: Legierungselemente**

| | Gew..-% | Gew.-% | Effekt |
|---|---|---|---|
| Sb | 2-20 | 5-15 | Mischkristallverfestigung (SnSb) |
| Sb-Sulfid(e) | 1-10 | 1-5 | Festschmierstoff |
| Sb-Oxid(e) | 1-7 | 1-3 | Erhöhung der Leitfähigkeit |
| Cu | 0,2-15 | 0,5-5 | Mischkristallverfestigung (Cu6Sn5) |
| Cu-Sulfid(e) | 0,5-8 | 1-4 | Festschmierstoff |
| Cu-Oxid(e) | 0,5-8 | 1-4 | Erhöhung der Festigkeit |
| In | 0,1-8 | 0,2-1,5 | Reduzierung der Korrosion durch Schmierölbestandteile |
| In-Sulfid(e) | 0,1-5 | 0,1-2 | Festschmierstoff |
| In-Oxid(e) | 0,1-5 | 0,1-2 | Erhöhung der Leitfähigkeit |
| Bi | 0,1-2 | 0,2-0,5 | Erhöhung der Festigkeit |
| Bi-Sulfid(e) | 0,01-2 | 0,01-1 | Festschmierstoff |
| Bi-Oxid(e) | 0,01-2 | 0,01-1,5 | Erhöhung der Festigkeit |
| Pb | 0,1-2 | 0,2-0,5 | Verbesserung der Tragfähigkeit |
| Pb-Sulfid(e) | 0,1-2 | 0,1-0,5 | Festschmierstoff |
| Pb-Oxid(e) | 0,1-2 | 0,1-0,5 | Erhöhung der Leitfähigkeit |

Neben diesen Legierungselemente und Legierungskomponenten kann die Zinnbasislegierung auch noch weitere Elemente enthalten, wie insbesondere Zr, Si, Zn, Ni, Ag, wobei deren Gesamtanteil an der Zinnbasislegierung auf maximal 3 Gew.-% beschränkt ist.

Die Gleitschicht 3 weist auf der Oberfläche, d.h. der Vorderseite 4, eine oxidische Subschicht 6 auf, wie dies aus Fig. 2 ersichtlich ist. Die oxidische Subschicht 6 wird zumindest teilweise aus dem Zinn der Zinnbasislegierung durch Oxidation gebildet. Der Anteil des Zinnoxids an der oxidischen Subschicht 6 beträgt zumindest 70 Gew.-%, insbesondere zumindest 90 Gew.-%. Die oxidische Subschicht 6 kann aber auch zur Gänze aus Zinnoxid(en) gebildet sein.

Vorzugsweise erstreckt sich die oxidische Subschicht über zumindest 80 % der Oberfläche, d.h. der Fläche der Vorderseite 4, insbesondere über zumindest 90 %. Es ist aber auch möglich, dass die oxidische Subschicht die gesamte Oberfläche, d.h. die gesamte der mit dem Schmiermittel, insbesondere Schmieröl, in Kontakt stehenden Lauffläche des Gleitlagers 1 bedeckt.

Es ist weiter bevorzugt, wenn zumindest 50 %, vorzugsweise zumindest 70 %, insbesondere zumindest 90 %, der Fläche der oxidischen Subschicht eine Schichtdicke 7 aufweisen, die mindestens 0,1 µm, vorzugsweise zumindest 0,3 µm, beträgt und/oder wenn zumindest 50 %, vorzugsweise zumindest 70 %, insbesondere zumindest 90 %, der Fläche der oxidischen Subschicht eine Schichtdicke 7 aufweisen, die maximal 2 µm, vorzugsweise maximal 0,7 µm, beträgt. Die Schichtdicke 7 wird insbesondere über die Dauer der Erzeugung der oxidischen Subschicht 6 eingestellt.

Zur Herstellung der oxidischen Subschicht 6 wird die Gleitschicht 3 auf das jeweilige Substrat, d.h. der Stützschicht 2 oder der Lagermetallschicht 5 oder der Zwischenschicht, wie voranstehend ausgeführt, in einem ersten Schritt abgeschieden, insbesondere galvanisch abgeschieden. Es sei dazu auf die AT 509 112 A1 verwiesen, auf die hinsichtlich der Abscheidebedingungen und der Elektrolyte ausdrücklich Bezug genommen wird.

Nach der Abscheidung der Gleitschicht 3 wird diese einer Oxidation unterzogen. Diese wird vorzugsweise durch (elektro)chemische Behandlung in oxidierenden Lösungen, wie z.B. eine saure (pH = 3 - 4) Permanganatlösung, etc., durchgeführt. Die Temperatur der (elektro)chemischen Behandlung kann zwischen 80 °C und 150 °C betragen. Falls die Oxidation elektrochemisch erfolgt, wird das Gleitlager als Anode geschaltet. Die anodische Oxidation kann mit einer Spannung zwischen 40 V und 60 V bei einer Stromdichte im Bereich zwischen 5 A/cm² und 15 A/cm² erfolgen.

Nach einer anderen Ausführungsvariante ist der Elektrolyt vorzugsweise organischer Natur, beispielsweise kann Ammoniumpentaborat in Ethylenglycol verwendet werden.

Die anodische Schichtbildung kann auch in einem organischen Elektrolyten der Klasse der ionischen Flüssigkeiten (beispielsweise 1-Butyl-3-methyl-imidazolium-bis-(trifluormethylsulfonyl)-imid) erfolgen. Da hierbei aufgrund des großen Stabilitätsfensters kaum Nebenreaktionen (wie Gasbildung) geschehen, wird die Schichtbildung durchgeführt bis die Spannung einen Wert von 40 V erreicht. Der Strom sinkt bis zum Erreichen der Spannung von 1 A/dm² auf unter 0,05 A/dm² ab. Durch die Wahl der Abbruchsspannung kann begrenzt die Schichtdicke eingestellt werden. Bei 40 V wird eine Dicke der Oxidschicht von durchschnittlich ca. 0,15 µm erreicht.

Es sind aber auch andere oxidative Behandlungen möglich, beispielsweise mit Wasserstoffperoxid, durch Oxidation mit einem Gas, wie z.B. Sauerstoff (50 Vol.-% bis 100 Vol.-%), Ozon, Wasserdampf, etc. Die Temperatur kann dabei ebenfalls zwischen 80 °C und 150 °C betragen.

Neben der bevorzugten Erzeugung der oxidischen Subschicht 6 aus zumindest einem Bestandteil der Gleitschicht 3 besteht aber auch die Möglichkeit, dass auf der Gleitschicht 3 die oxidische Subschicht 6 durch Abscheidung erzeugt wird, beispielsweise mittels Gasphasenabscheidung bzw. Kathodenzerstäubung. Beispielsweise kann die Gleitschicht durch reaktives Sputtern abgeschieden werden. Die Gleichspannung dazu kann zwischen 1000 V und 3000 V bei einem Entladungsstrom zwischen 6 mA und 15 mA.

Gleichzeitig mit oder nach der oxidierenden Behandlung der Gleitschicht 3 ist es möglich, die Gleitschicht 3 zu sulfidieren. Beispielsweise kann der oxidierenden Atmosphäre H2S oder ein Mercaptan zugesetzt werden. Es können damit die in Tabelle 1 genannten Sulfide erzeugt werden, sofern diese nicht ohnehin als Sulfide zugesetzt werden.

Neben der Ausbildung der oxidischen Subschicht 6 ist es weiter möglich, dass die die Gleitschicht unterhalb der oxidischen Subschicht 6 oxidische Bereiche aufweist. Vorzugsweise weisen diese oxidischen Bereiche ebenfalls Zinnoxid(e) auf. Es können aber auch andere Oxide vorhanden sein, insbesondere jene die in Tabelle 1 genannt sind. Der Anteil dieser Oxide unterhalb der oxidischen Subschicht 6 beträgt vorzugsweise zwischen 0,5 Gew.-% und 15 Gew.-%. Diese oxidischen Bereiche 8 können durch das Beimengen von Oxiden zu den Legierungsbestandteilen zur Herstellung der Gleitschicht 3 eingebracht werden.

Nach einer weiteren, bevorzugten Ausführungsvariante besteht das Zinnoxid der oxidischen Subschicht 6 zu mehr als 40 Gew.-%, insbesondere zu mehr als 70 Gew.-%, aus der Modifikation Romarchit.

Es ist darüber hinaus möglich, dass neben zweiwertigem Zinnoxid auch vierwertiges Zinnoxid in der oxidischen Subschicht 6 enthalten ist. Dies wird durch eine Wärmebehandlung der Gleitschicht erreicht.

Neben der Ausbildung der oxidischen Subschicht 6 ausschließlich aus Zinnoxid(en) kann vorgesehen werden, dass in der oxidischen Subschicht 6 zumindest ein weiteres Legierungselement bzw. eine weitere Legierungskomponente enthalten. Dieses ist bzw. diese sind insbesondere ausgewählt aus den Legierungselementen bzw. Legierungskomponenten die in Tabelle 1 genannt sind, wobei auch die angegebenen Mengenbereiche Anwendung finden können. Zudem können in der oxidischen Subschicht 6 auch noch zumindest ein Element aus einer Gruppe umfassend oder bestehend aus H, C, S enthalten sein. Beispielsweise kann die oxidische Subschicht 6 die in Tabelle 2 angeführten weiteren Legierungselemente bzw. Legierungskomponenten enthalten. Die Angaben sind in Gew.-% zu verstehen. Den Rest auf 100 Gew.-% bildet jeweils das Zinnoxid bzw. bilden jeweils die Zinnoxide.

Der Vollständigkeit halber sei an dieser Stelle angemerkt, dass die Oxide in der oxidischen Subschicht 6 teilweise auch als Hydroxide und/oder Oxihydrate vorliegen können.

Antimon kann als 3- und/oder 5- und/oder gemischtes 3-/5-wertiges Oxid und/oder Sulfid vorliegen.
Kupfer kann als 1- und/oder 2-wertiges Oxid und/oder Sulfid vorliegen
Indium kann als 3-wertiges Oxid und/oder Sulfid vorliegen

Wismut kann als 3- und/oder 5- Oxid und/oder Sulfid vorliegen.

Blei kann als 2- und/oder 4- und/oder gemischtes 2-/4-wertiges Oxid und/oder Sulfid vorliegen.

Diese Angaben betreffend die Oxide und Sulfide der Metalle treffen auf die Gleitschicht 3 und/oder auf die oxidische Subschicht 6 zu. Daneben können in der Gleitschicht 3 und/oder oxidischen Subschicht 6 auch die Metalle an sich, wie dies voranstehend bereits ausgeführt wurde, vorliegen.

**Tabelle 2: Beispiele für Zusammensetzungen der oxidischen Subschicht 6**

| Nr. | 1 | 2 | 3 | 4 | 5 | 6 | 7 | 8 | 9 | 10 | 11 | 12 | 13 | 14 | 15 |
|---|---|---|---|---|---|---|---|---|---|---|---|---|---|---|---|
| s | | | | | | | | | 1,5 | | | | 0,025 | | |
| Sb-Sulfid(e) | 2 | 7 | | | | | | | 8 | 5 | | 2,5 | 1 | 10 | |
| Sb-Oxid(e) | | | 3 | | 4 | | | | | 3 | | 1 | | 7 | |
| Cu-Sulfid(e) | | | | 7 | | | | | | 4 | | 1,8 | | | 8 |
| Cu-Oxid(e) | | | | | 2,4 | | | | | 1,5 | | 0,5 | | | 8 |
| In-Sulfid(e) | | | | | | 1,5 | 3,8 | | | | | 0,1 | | | |
| In-Oxid(e) | | | | | | | 4 | | | | 2,5 | 0,1 | | | |
| Bi-Sulfid(e) | | | | | | | | 0,9 | | | 1 | | | | |
| Bi-Oxid(e) | | | | | | | | 0,5 | | | 1,8 | | 0,7 | | |
| Pb-Sulfid(e) | | | | | | | | | 0,1 | | | | 0,7 | | |
| Pb-Oxid(e) | | | | | | | | | 0,1 | | | | | | |
| Schichtdicke [µm] | 0,15 | 1,15 | 0,45 | 0,85 | 1,5 | 0,4 | 1,1 | 0,25 | 1,3 | 1,6 | 0,75 | 0,8 | 0,9 | 1,8 | 1,9 |

Neben den voranstehend genannten Legierungselementen bzw. Legierungskomponenten kann die oxidische Subschicht 6 noch weitere Legierungsbestandteile aufweisen. Insbesondere kann die oxidische Subschicht 6 zumindest ein weiteres Oxid aus einer Gruppe umfassend oder bestehend aus Chromoxid(en), Molybdänoxid(en), Wolframoxid(en), Manganoxid(en), Nickeloxid(en) enthalten.

Beispielsweise kann die oxidische Subschicht 6 MnO₂ enthalten. Dazu kann die elektrochemische Oxidation in einer Permanganatlösung bei einem pH-Wert von 3 - 4 und einer Temperatur zwischen 80 °C und 150 °C erfolgen. Die anodische Oxidation kann mit einer Spannung zwischen 40 V und 60 V bei einer Stromdichte im Bereich zwischen 5 A/cm² und 15 A/cm² erfolgen.

Zur Erzeugung von Wolframoxiden kann eine Ammoniumwolframatlösung verwendet werden. Die Abscheidung kann bei einem pH-Wert zwischen 8 und 9 und bei einer Temperatur zwischen 80 °C und 150 °C erfolgen. Die Spannung kann zwischen 10 V und 20 V und die Stromdichte im Bereich zwischen 5 A/dm² und 15 A/dm² betragen.

Der Summenanteil an Chromoxid(en), Molybdänoxid(en), Wolframoxid(en), Manganoxid(en), Nickeloxid(en) kann zwischen 4 Gew.-% und 15 Gew.-% betragen.

Insbesondere kann der Anteil an Chromoxid(en) zwischen 0,1 Gew.-% und 6 Gew.-% und/oder der Anteil an Molybdänoxid(en) zwischen 0,1 Gew.-% und 5 Gew.-% und/oder der Anteil an Wolframoxid(en) zwischen 0,1 Gew.-% und 6,5 Gew.-% und/oder der Anteil an Manganoxid(en) zwischen 0,1 Gew.-% und 8 Gew.-% und/oder der Anteil an Nickeloxid(en) zwischen 0,1 Gew.-% und 5 Gew.-% betragen.

Nach einer anderen Ausführungsvariante ist vorgesehen, dass die oxidische Subschicht 6 Poren 9 und/oder Risse 10 aufweist, wie dies in Fig. 2 strichliert angedeutet ist. Erreicht wird dies durch entsprechende Adaptierung der galvanischen Bäder und/oder durch die Variation der Verfahrensparameter, beispielsweise indem kurz vor dem Beenden der galvanischen Abscheidung der Gleitschicht 3 eine Gasbildung in dem galvanischen Bad zugelassen wird.

Die Poren 9 können einen maximalen Durchmesser zwischen 0,5 µm und 3 µm und/oder einer Porentiefe zwischen 0,1 x der Schichtdicke der oxidischen Subschicht 6 und 1 x der Schichtdicke der oxidischen Subschicht 6 aufweisen.

Die Risse 10 können eine Länge zwischen 0,1 x der Schichtdicke der oxidischen Subschicht 6 und 5 x der Schichtdicke der oxidischen Subschicht 6 und/oder einer Risstiefe zwischen 0,1 x der Schichtdicke der oxidischen Subschicht 6 und 1 x der Schichtdicke der oxidischen Subschicht 6 aufweisen.

Im Rahmen von Versuchen an derartigen Mehrschichtgleitlagern 1 wurde ein Gleitlager hergestellt, bestehend aus einer Stützschicht 2 aus Stahl, einer darauf aufgebrachten CuSn5Zn-Schicht als Lagermetallschicht 5, eine darauf aufgebrachte Ni-Sperrschicht, eine auf diese galvanisch abgeschiedene SnCu5-Gleitschicht 3, die eine oxidische Subschicht 6 aus SnO aufwies. Die Schichtdicke 7 der oxidischen Subschicht 6 betrug zwischen 0,3 µm und 0,7 µm.

Als Vergleichsbeispiel wurde dasselbe Mehrschichtgleitlager hergestellt, allerdings ohne die oxidische Subschicht 6.

Zur Prüfung wurden diese beiden Mehrschichtgleitlager 1 einem Laserscreening unterzogen. Dabei wurden die Oberflächen der Gleitschichten 3 mit einem Laserstrahl unter den gleichen Bedingungen gerastert, sodass sich die Oberflächen der Gleitschichten 3 der beiden Mehrschichtgleitlager 1 auf die gleiche Temperatur erwärmten. In der Folge wurde das Abkühlen der Gleitschichten 3 über die Zeit aufgezeichnet.

Bei dem Mehrschichtgleitlager 1 mit der oxidischen Subschicht 6 klingt die Temperatur deutlich langsamer ab, als bei dem Mehrschichtgleitlager 1 ohne die oxidische Subschicht 6. Zudem war die Oberfläche des Vergleichsbeispiels angeschmolzen.

Es wurden weitere Testmuster mit Gleitschichten 3 hergestellt, die zumindest eines der Legierungselemente bzw. zumindest eine der Legierungskomponenten entsprechend Tabelle 1 und in den in Tabelle 1 angegebenen Mengenanteilen aufwiesen.

Sämtliche dieser Beispiele zeigten beim Laserscreening, wie dieses voranstehend beschrieben wurde, eine deutlich geringere Durchwärmung der Gleitschicht 3, als die Vergleichsmuster mit derselben Zusammensetzung aber ohne die oxidische Subschicht. In weiteren Testversuchen wurden Mehrschichtgleitlager 1 mit oxidischen Subschichten 6 hergestellt, die aus 40 Gew.-% bzw. 50 Gew.-% bzw. 95 Gew.-% Sn(II)oxid in der Modifikation Romarchit bestanden. Diese Testmuster wurden mit Gleitschichten mit oxidischen Subschichten 6 verglichen, die einen Anteil von weniger als 40 Gew.-% Sn(II)oxid in der Modifikation Romarchit aufwiesen. Es zeigte sich, dass die Temperaturbelastbarkeit der Gleitschicht 3 über die Zeit und/oder die Höhe der Temperatur um zumindest 10 % besser war, als jene der Gleitschichten 3 mit weniger als 40 Gew.-% Romarchit.

Weiter wurde untersucht, wie sich das Ausmaß der Flächenbelegung der Oberfläche der Gleitschicht 3 mit der oxidischen Subschicht 6 auswirkt. Dazu wurden Testmuster hergestellt, bei denen die Oberfläche der Gleitschicht 3 zu 50 % bzw. zu 60 % bzw. zu 70 % bzw. zu 80 % bzw. zu 90% bzw. zu 100 % mit der oxidischen Subschicht 6 bedeckt war. Überraschenderweise konnte dabei festgestellt werden, dass eine vollständige Flächenbelegung mit der oxidischen Subschicht 6, d.h. eine die Gleitschicht 3 vollständig bedeckende oxidische Subschicht 6, nicht notwendig ist, um die voranstehenden Effekte zu erreichen. Das kritische Ausmaß der Flächenbelegung wurde im Zuge dieser Tests mit zumindest 50 % festgestellt.

Auch der Einfluss von Poren 9 und Rissen 10 auf die Effektivität der oxidischen Subschicht wurde untersucht. Dazu wurde die oxidische Subschicht 6 mit Poren 9 mit einem Durchmesser entsprechend voranstehenden Werten und Risse 10 mit einer Risslänge entsprechend voranstehenden Werten hergestellt. Nach dem Testlauf des Mehrschichtgleitlagers 1 wurde dieses dem voranstehend genannten Laserscreening unterzogen, wobei überraschenderweise eine bessere Performance erreicht wurde, als mit einem Mehrschichtgleitlager 1 mit einer poren- und rissfreien oxidischen Subschicht. Eine nachfolgende mikroskopische Untersuchung zeigte, dass in die Poren und Risse Schmiermittel eingelagert war. Die bessere Performance wird auf diese Einlagerung zurückgeführt.

Die Ausführungsbeispiele beschreiben mögliche Ausführungsvarianten des Mehrschichtgleitlagers 1, wobei an dieser Stelle bemerkt sei, dass auch diverse Kombinationen der einzelnen Ausführungsvarianten untereinander möglich sind.

Der Ordnung halber sei abschließend darauf hingewiesen, dass zum besseren Verständnis des Aufbaus Mehrschichtgleitlagers 1 dieses bzw. dessen Bestandteile teilweise unmaßstäblich und/oder vergrößert und/oder verkleinert dargestellt wurden.

### Bezugszeichenaufstellung

- 1: Mehrschichtgleitlager
- 2: Stützschicht
- 3: Gleitschicht
- 4: Vorderseite
- 5: Lagermetallschicht
- 6: Subschicht
- 7: Schichtdicke
- 8: Bereich
- 9: Pore
- 10: Riss

## Patentansprüche

1. Mehrschichtgleitlager (1) umfassend eine Gleitschicht (3) mit einer Oberfläche zur Anlage an ein zu lagerndes Bauteil, wobei die Gleitschicht (3) aus einer Zinnbasislegierung mit Zinn als Hauptlegierungselement gebildet ist, **dadurch gekennzeichnet, dass** die Gleitschicht (3) an der Oberfläche zumindest bereichsweise eine oxidische Subschicht (6) aufweist, in der der Anteil an Zinnoxid oder Zinnoxidenen zumindest 70 Gew.-% beträgt.

2. Mehrschichtgleitlager (1) nach Anspruch 1, **dadurch gekennzeichnet, dass** sich die oxidische Subschicht (6) über zumindest 80 % der Oberfläche erstreckt.

3. Mehrschichtgleitlager (1) nach Anspruch 1 oder 2, **dadurch gekennzeichnet, dass** zumindest 50 % der Fläche der oxidischen Subschicht (6) eine Schichtdicke (7) aufweisen, die mindestens 0,1 µm beträgt.

4. Mehrschichtgleitlager (1) nach einem der Ansprüche 1 bis 3, **dadurch gekennzeichnet, dass** zumindest 50 % der Fläche der oxidischen Subschicht (6) eine Schichtdicke (7) aufweisen, die maximal 2 µm beträgt.

5. Mehrschichtgleitlager (1) nach einem der Ansprüche 1 bis 4, **dadurch gekennzeichnet, dass** die Gleitschicht (3) unterhalb der oxidischen Subschicht (6) oxidische Bereiche (8) aufweist.

6. Mehrschichtgleitlager (1) nach einem der Ansprüche 1 bis 5, **dadurch gekennzeichnet, dass** das Zinnoxid zu mehr als 40 Gew.-% in der Modifikation Romarchit vorliegt.

7. Mehrschichtgleitlager (1) nach Anspruch 6, **dadurch gekennzeichnet, dass** neben Romarchit auch vierwertiges Zinnoxid in der oxidischen Subschicht enthalten ist.

8. Mehrschichtgleitlager (1) nach einem der Ansprüche 1 bis 7, **dadurch gekennzeichnet, dass** in der oxidischen Subschicht (6) zumindest ein Legierungselement und/oder eine Legierungskomponente enthalten ist, das/die ausgewählt ist aus einer Gruppe umfassend Kohlenstoff, Wasserstoff und Schwefel.

9. Mehrschichtgleitlager (1) nach einem der Ansprüche 1 bis 8, **dadurch gekennzeichnet, dass** in der oxidischen Subschicht (6) zumindest ein Legierungselement und/oder eine Legierungskomponente enthalten ist, das/die ausgewählt ist aus einer Gruppe umfassend Antimon, Kupfer, Indium, Bismut, Blei sowie die Oxide dieser Elemente und die Sulfide dieser Elemente.

10. Mehrschichtgleitlager (1) nach einem der Ansprüche 1 bis 9, **dadurch gekennzeichnet, dass** die oxidische Subschicht (6) Poren (9) und/oder Risse (10) aufweist.

## Claims

1. A multi-layer sliding bearing (1) comprising a sliding layer (3) having a surface for contacting a component to be borne, wherein the sliding layer (3) is made from a tin-based alloy with tin as the main alloying element, **characterized in that** the sliding layer (3) has, at least in some sections, an oxidic sub-layer (6) on the surface, in which sub-layer (6) the proportion of tin oxide or tin oxides is at least 70 wt.%.

2. The multi-layer sliding bearing (1) according to claim 1, **characterized in that** the oxidic sub-layer (6) extends across at least 80 % of the surface.

3. The multi-layer sliding bearing (1) according to claim 1 or 2, **characterized in that** at least 50 % of the area of the oxidic sub-layer (6) has a layer thickness (7) of at least 0.1 µm.

4. The multi-layer sliding bearing (1) according to one of claims 1 to 3, **characterized in that** at least 50 % of the area of the oxidic sub-layer (6) has a layer thickness (7) of a maximum of 2 µm.

5. The multi-layer sliding bearing (1) according to one of claims 1 to 4, **characterized in that** the sliding layer (3) has oxidic regions (8) underneath the oxidic sub-layer (6).

6. The multi-layer sliding bearing (1) according to one of claims 1 to 5, **characterized in that** the tin oxide is present in the modification romarchite at more than 40 wt.% .

7. The multi-layer sliding bearing (1) according to claim 6, **characterized in that** in addition to romarchite, there is also tetravalent tin oxide present in the oxidic sub-layer.

8. The multi-layer sliding bearing (1) according to one of claims 1 to 7, **characterized in that** the oxidic sub-layer (6) contains at least one alloying element and/or an alloying component, which is selected from a group comprising carbon, hydrogen and sulfur.

9. The multi-layer sliding bearing (1) according to one of claims 1 to 8, **characterized in that** the oxidic sub-layer (6) contains at least one alloying element and/or one alloying component which is selected from a group comprising antimony, copper, indium, bismuth, lead as well as the oxides of said elements and the sulfides of said elements.

10. The multi-layer sliding bearing (1) according to one of claims 1 to 9, **characterized in that** the oxidic sub-layer (6) comprises pores (9) and/or cracks (10).

## Revendications

1. Palier lisse multicouche (1), comportant une couche antifriction (3) ayant une surface destinée à venir en contact avec un composant devant être supporté, la couche antifriction (3) étant formée d'un alliage à base d'étain dont l'étain est l'élément principal de l'alliage, **caractérisé en ce que** la couche antifriction (3) comporte en surface, au moins par endroits, une sous-couche (6) de type oxyde dans laquelle la proportion d'oxyde d'étain ou d'oxydes d'étain est au moins égale à 70 %-poids.

2. Palier lisse multicouche (1) selon la revendication 1, **caractérisé en ce que** la sous-couche (6) de type oxyde s'étend sur au moins 80 % de la surface.

3. Palier lisse multicouche (1) selon la revendication 1 ou 2, **caractérisé en ce qu'**au moins 50 % de la surface de la sous-couche (6) de type oxyde présentent une épaisseur de couche (7) qui est au moins égale à 0,1 µm.

4. Palier lisse multicouche (1) selon l'une des revendications 1 à 3, **caractérisé en ce qu'**au moins 50 % de la surface de la sous-couche (6) de type oxyde présentent une épaisseur de couche (7) qui est au maximum égale à 2 µm.

5. Palier lisse multicouche (1) selon l'une des revendications 1 à 4, **caractérisé en ce que** la couche antifriction (3) présente des zones (8) de type oxyde au-dessous de la sous-couche (6) de type oxyde.

6. Palier lisse multicouche (1) selon l'une des revendications 1 à 5, **caractérisé en ce que** l'oxyde d'étain est présent à raison de plus de 40 %-poids dans la modification romarchite.

7. Palier lisse multicouche (1) selon la revendication 6, **caractérisé en ce que**, outre la romarchite, la sous-couche de type oxyde contient également de l'oxyde d'étain tétravalent.

8. Palier lisse multicouche (1) selon l'une des revendications 1 à 7, **caractérisé en ce que** la sous-couche (6) de type oxyde contient au moins un élément d'alliage et/ou une composante d'alliage qui est sélectionné(e) dans un groupe comprenant du carbone, de l'hydrogène et du soufre.

9. Palier lisse multicouche (1) selon l'une des revendications 1 à 8, **caractérisé en ce que** la sous-couche (6) de type oxyde contient au moins un élément d'alliage et/ou une composante d'alliage qui est sélectionné(e) dans un groupe comprenant de l'antimoine, du cuivre, de l'indium, du bismuth, du plomb ainsi que les oxydes de ces éléments et les sulfures de ces éléments.

10. Palier lisse multicouche (1) selon l'une des revendications 1 à 9, **caractérisé en ce que** la sous-couche (6) de type oxyde comporte des pores (9) et/ou des fissures (10).
